Europäisches Patentamt

(19) European Patent Office

Office européen des brevets

(11) Numéro de publication: **0 229 433**
**B1**

(12) **FASCICULE DE BREVET EUROPEEN**

(45) Date de publication du fascicule du brevet: **08.08.90**

(51) Int. Cl.⁵: **G 06 F 11/26**, G 01 R 31/28

(21) Numéro de dépôt: **86202394.2**

(22) Date de dépôt: **30.12.86**

(54) **Dispositif de test de circuit logique combinatoire.**

(30) Priorité: **10.01.86 FR 8600275**

(43) Date de publication de la demande:
**22.07.87 Bulletin 87/30**

(45) Mention de la délivrance du brevet:
**08.08.90 Bulletin 90/32**

(84) Etats contractants désignés:
**DE FR GB IT**

(56) Documents cités:
**US-A-3 924 181**
**US-A-4 045 736**

**IEEE INTERNATIONAL SYMPOSIUM ON FAULT-TOLERANT COMPUTING, Los Angeles, 28-30 juin 1977, Symposium 7, pages 81-87, IEEE, New York, US; S.M. THATTE et al.: "Testing of semiconductor random access memories"**

**INFORMATIQUE ET MATHEMATIQUES APPLIQUEES DE GRENOBLE, rapport de recherche, R.R. No. 533, mai 1985, Grenoble, FR; D. BASCHIERA et al.: "Testing s-opens of CMOS gates and networks"**

(73) Titulaire: **TELECOMMUNICATIONS RADIOELECTRIQUES ET TELEPHONIQUES T.R.T.**
**88, rue Brillat Savarin**
**F-75013 Paris (FR)**
(84) **FR**

(73) Titulaire: **N.V. Philips' Gloeilampenfabrieken**
**Groenewoudseweg 1**
**NL-5621 BA Eindhoven (NL)**
(84) **DE GB IT**

(72) Inventeur: **Baschiera, Daniel Société Civile S.P.I.D.**
**209, rue de l'Université**
**F-75007 Paris (FR)**
Inventeur: **Courtois, Bernard Société Civile S.P.I.D.**
**209, rue de l'Université**
**F-75007 Paris (FR)**

(74) Mandataire: **Chaffraix, Jean et al**
**Société Civile S.P.I.D. 209, rue de l'Université**
**F-75007 Paris (FR)**

Courier Press, Leamington Spa, England.

## Description

La présente invention concerne un dispositif de test d'un circuit logique combinatoire, comportant d'une part un circuit générateur de séquences de test pour appliquer à N entrées du circuit logique combinatoire des signaux logiques de test et d'autre part un circuit de sortie pour analyser les signaux de sortie du circuit logique combinatoire, ces séquences de test consistant à appliquer successivement à chacune des N entrées une suite alternée, au moins deux fois, de "1" et de "0" logiques tandis qu'aux autres entrées est appliqué un mot de N-1 éléments binaires pour assurer la transmission de ladite suite alternée vers la sortie du circuit logique combinatoire.

Un tel dispositif trouve des applications importantes surtout pour le test des circuits logiques intégrés selon la technologie C.MOS. Cette technologie permet un haut degré d'intégration, ce qui impose des tests pour vérifier le bon fonctionnement du circuit non seulement en fin de fabrication, mais aussi lorsqu'il est inséré dans un montage. Pour cela on prévoit des périodes de vérification en dehors du fonctionnement normal du montage.

De nombreuses méthodes pour effectuer ces tests ont été décrites. Par exemple, une méthode pour effectuer des tests sur un circuit logique combinatoire est décrite dans le document US—A—3 924 181, où un générateur de test pseudo-aléatoire, formé à partir d'un registre à décalage auquel est associé un réseau de réinjection, fournit des vecteurs à N éléments binaires au circuit logique combinatoire à tester. Cependant, il convient de souligner la méthode qui préconise d'appliquer à chacune des N entrées une suite alternée de "1" et de "0", tandis qu'aux autres entrées est appliqué un mot de N-1 éléments binaires pour assurer la transmission de ladite suite alternée vers la sortie du circuit logique combinatoire. Cette méthode bien décrite dans le rapport de recherche RR533 publié en mai 1985 et édité par IMAG, 46 Avenue Félix Viallet 38031 Grenoble CEDEX FRANCE, évite les réponses fallacieuses du circuit logique se comportant pour certaines pannes comme un circuit séquentiel.

La présente invention propose donc un dispositif de test répondant aux exigences formulées dans le rapport de recherche précité. A cet effet, un dispositif de test du genre mentionné dans le préambule est remarquable en ce que le générateur de séquences de test est constitué d'un générateur de séquences pseudo-aléatoire à N éléments binaires, formé à partir d'un registre à décalage auquel est associé un réseau de réinjection, d'un circuit de sélection d'élément binaire pour sélectionner successivement chacun des N éléments binaires, d'un circuit d'inversion pour inverseur au moins deux fois l'élément binaire sélectionné.

Ainsi un tel dispositif de test, réalisé dans la même technologie C.MOS que le circuit logique combinatoire à tester, occupe une place réduite sur une plaquette de silicium. Il faut noter que dans le cas où un circuit intégré comporte un tel dispositif, le dispositif de test doit présenter une complexité nettement inférieure à celle du circuit logique combinatoire à tester puisque le nombre de pannes dépend directement de cette complexité.

La description suivante faite en regard des dessins annexés, le tout donné à titre d'exemple non limitatif, fera bien comprendre comment l'invention peut être réalisée.

La figure 1 représente un dispositif de test conforme à l'invention.

La figure 2 représente la structure d'une porte NON-ET réalisée en technologie C.MOS.

La figure 3 représente la structure d'un inverseur de signaux logiques réalisé en technologie C.MOS.

La figure 4 représente la structure d'un organe de transfert convenant pour une réalisation en technologie C.MOS.

Les figures 5a et 5b représentent des bascules de transfert avec remise à "0" et à "1" respectivement.

La figure 6 montre l'allure des organes convenant pour les bascules des figures 5a et 5b.

La figure 7 montre la structure d'un circuit de commande faisant partie du dispositif de l'invention montré à la figure 1.

La figure 8 montre un diagramme temps destiné à l'explication du fonctionnement du circuit de commande de la figure 7.

La figure 9 montre un exemple de réalisation préfére du générateur de séquences de test.

La figure 10 montre un détecteur de parité faisant partie du générateur de la figure 9.

La figure 11 montre la structure du circuit de commande convenant pour le générateur de la figure 9.

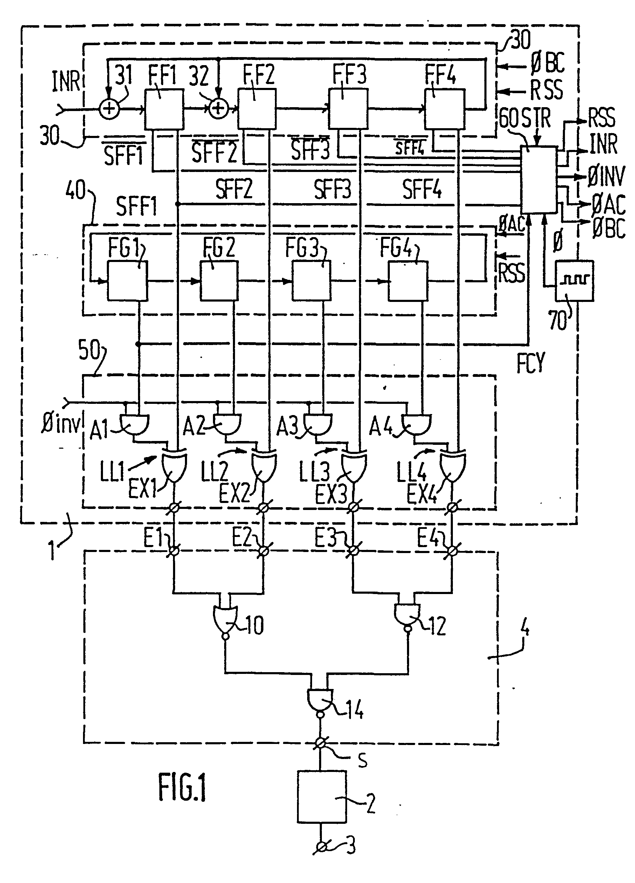

Le dispositif de test montré à la figure 1 est formé de deux parties: la première partie est constituée par un générateur de séquences de test portant la référence 1 et la deuxième, par un circuit de sortie 2 fournissant sur une borne de sortie 3 un signal indiquant si un circuit logique combinatoire à tester 4 a un fonctionnement satisfaisant en fonction de l'analyse de signature. A ce sujet on pourra consulter l'article "Signature Analysis: A New Digital Field Service Method" par Robert A. Frohwerk paru dans "Hewlett Packard Journal", Mai 1977, Vol. 28, No. 9, pages 1 à 8.

Afin de faciliter la description de la présente invention, le circuit logique à tester 4 présente une structure simple; mais il va de soi que dans la pratique, le dispositif de l'invention trouve son intérêt dans le cas notamment où ce circuit 4 est de structure complexe.

Ce circuit logique combinatoire est muni de quatre entrées E1, E2, E3 et E4 et d'une sortie S; il comporte une porte NON-OU 10 dont les deux entrées sont reliées aux bornes E1 et E2, une première porte NON-ET 12 dont les deux entrées sont reliées aux bornes E3 et E4 et une deuxième porte NON-ET 14 dont les deux entrées sont reliées respectivement aux deux sorties des portes 10 et 12 et dont la sortie constitue la sortie S du circuit 4.

Selon la méthode de test préconisée dans le rapport de recherche précité, on teste la transmission d'une suite alternée de signaux logiques 1, 0, 1 ou 0, 1, 0 appliquée à l'une des entrées E1, E2, E3 ou E4 tandis qu'aux entrées les signaux doivent permettre la transmission de cette séquence. Par exemple si l'on veut tester la transmission de la suite alternée appliquée à l'entrée E1, il faut que la porte 10 soit à l'état passant, c'est-à-dire qu'en E2 on doit avoir un signal logique "0", et que la porte 14 le soit aussi, c'est-à-dire que le signal à la sortie de la porte 12 doit avoir la valeur "1". Pour avoir ce signal de valeur "1" à la sortie de la porte 12, il faut qu'au moins un des signaux appliqués aux entrées E3 et E4 ait la valeur "0". Pour tester la transmission de la suite alternée appliquée à l'entrée E2, on doit avoir à l'entrée E1 un signal "0" et aux entrées E3 et E4 au moins un signal "0". Pour l'entrée E3, il faut qu'un signal "1" soit appliqué à l'entrée E4 et que des signaux de valeur logique "0" soit appliqués aux entrées E1 et E2. Pour l'entrée E4, il faut qu'un signal "1" soit appliqué à l'entrée E3 et des signaux "0", aux entrées E1 et E2.

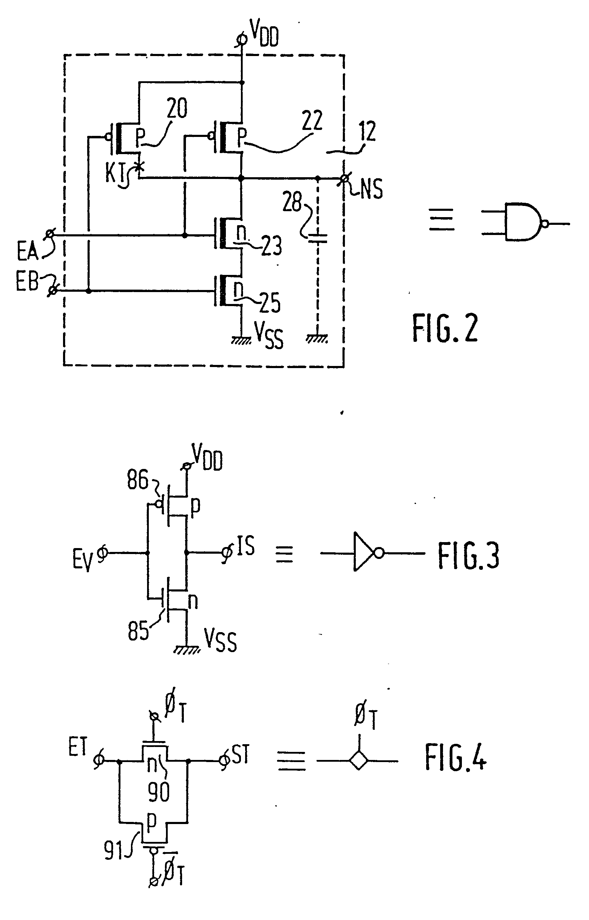

Pour bien comprendre l'intérêt de cette méthode, on se reporte à la figure 2 où la porte NON-ET 12 ou 14 est représentée en détail en technologie C.MOS.

La porte représentée à la figure 2 est formée de deux transistors MOS canal "p" 20 et 22 montés en parallèle, c'est-à-dire que leurs sources et drains sont interconnectés, et de deux transistors MOS 23 et 25 canal "n" montés en série. La source du transistor 25 est au potentiel commun VSS et les sources des transistors 20 et 22 au potentiel d'alimentation VDD. Les drains des transistors 20 et 22 sont connectées au drain du transistor 23. Les signaux d'entrée de cette porte sont appliqués aux entrées EA et EB. L'entrée EA est constituée par les grilles des transistors 22 et 23 et l'entrée EB par les grilles des transistors 20 et 25. La sortie NS est prise sur le drain du transistor 23.

Quand cette porte fonctionne correctement, il est facile de voir que, pour avoir un signal de valeur basse (VSS) à la sortie NS, il faut que les transistors 23 et 25 conduisent et que les transistors 20 et 22 soient bloqués, ce qui implique donc que les signaux en EA et EB soient tous deux de valeur haute (VDD). Si un seul, ou les deux signaux d'entrée ont une valeur basse, un des deux ou les deux transistors 20 et 22 conduisent tandis que l'un ou les deux transistors 23 et 25 sont bloqués. La valeur du signal à la sortie NS est donc haute.

La table de vérité s'écrit donc, comme cela est bien connu, de la façon suivante sur le tableau I où B et H représentent respectivement les valeurs basse et haute des signaux, c'est-à-dire des "0" et "1" logiques.

TABLEAU I

| EA | EB | NS |
|----|----|----|
| B | B | H |
| B | H | H |
| H | B | H |
| H | H | B |

Sur la figure 2 on a représenté en pointillé un condensateur 28 représentant la capacité apportée par l'étage suivant (la porte 14).

La référence KT représente une coupure au niveau du drain du transistor 20. Alors, on effectue le test en appliquant successivement les signaux de valeur H et B aux entrées EA et EB dans l'ordre indiqué au tableau I, le condensateur 28 chargé à l'état où EA=B et EB=B le restera pour les autres états où EA=B, EB=H et EA=H et EB=B; le signal à la sortie NS prendra la valeur B lorsque EA=H et EB=H.

Selon la méthode proposée, pour détecter la coupure KT, il faut appliquer une valeur "1" ou H à l'entrée EA et une suite alternée, par exemple H, B, H à l'entrée EB. Il est à noter que l'on teste ainsi la possibilité d'une coupure du transistor 25. Le tableau II donne la valeur NS pour le cas de la porte en bon état.

TABLEAU II

| EA | EB | NS |
|----|----|----|
| H | H | B |
| H | B | H |
| H | H | B |

On voit que dans ce cas, la suite alternée est transmise en complément.

Si on examine maintenant le cas où l'on considère la coupure KT, on voit sur le tableau III que cette séquence n'est pas transmise, la coupure KT empêchant la condensateur 28 de se charger à l'état où EA=H et EB=B.

TABLEAU III

| EA | EB | NS |
|----|----|----|
| H | H | B |
| H | B | B |
| H | H | B |

En se reportant au rapport précité, on trouvera d'autres exemples mettant en évidence l'efficacité de la méthode.

Selon l'invention, pour tester le circuit logique combinatoire 4, le générateur de séquences de test 1 est constitué d'un générateur de séquences pseudo-aléatoire 30 à quatre éléments binaires formé d'un registre à décalage comprenant quatre bascules FF1, FF2, FF3, FF4 fournissant respectivement les signaux SFF1 et SSF1 pour la première, SFF2 et SSF2 pour la seconde, SFF3 et SSF3 pour la troisième, enfin SFF4 et SSF4 pour la quatrième. A ces bascules est associé un réseau de réinjection comprenant deux portes OU-EXCLUSIF portant les références 31 et 32. La porte 31 est insérée entre les bascules FF4 et FF1 et la porte 32 entre la bascule FF1 et FF2. Au niveau de la porte 31 on injecte un signal d'entrée INR et au niveau de la porte 32 le signal de sortie de la bascule FF4. Un tel générateur de séquences pseudo-aléatoire fournit des mots binaires ou vecteurs survenant successivement comme indiqué au tableau IV. On remarque que l'on passe du vecteur n° 0 au vecteur n° 1 en appliquant un signal INR de valeur "1" à l'entrée de la bascule FF1 puis, après cette injection, le signal INR garde le niveau "0". Le générateur de test 1 est aussi constitué d'un circuit de sélection d'éléments binaires 40 comprenant quatre bascules FG1, FG2, FG3 et FG4 montées en registré à décalage de façon qu'un signal actif à la sortie de la bascule FG1 puisse sélectionner le signal SFF1, qu'un signal actif à la sortie de la bascule FG2 puisse sélectionner le signal SFF2, qu'un signal actif à la sortie de la bascule FG3 puisse sélectionner le signal SFF3, et enfin qu'un signal actif à la sortie de la bascule FG4 puisse sélectionner le signal SFF4.

Le générateur 1 est pourvu en outre d'un circuit d'inversion 50 pour inverser au moins deux fois l'élément binaire sélectionné. Ce circuit d'inversion est formé de quatre circuits logiques élémentaires LL1, LL2, LL3 et LL4.

TABLEAU IV

| n° Vecteur | Entrée FF1:SFF4 ⊕INR | Sortie SFF1 | Entrée FF2:SFF1 ⊕SFF4 | SFF2 | SFF3 | SFF4 | Vecteur fourni |
|---|---|---|---|---|---|---|---|
| 0 | 0 | 0 | 0 | 0 | 0 | 0 | 0000 |
|  | →1 |  |  |  |  |  |  |
| 1 | 0 | 1 | 1 | 0 | 0 | 0 | 1000 |
| 2 | 0 | 0 | 0 | 1 | 0 | 0 | 0100 |
| 3 | 0 | 0 | 0 | 0 | 1 | 0 | 0010 |
| 4 | 1 | 0 | 1 | 0 | 0 | 1 | 0001 |
| 5 | 0 | 1 | 1 | 1 | 0 | 0 | 1100 |
| 6 | 0 | 0 | 0 | 1 | 1 | 0 | 0110 |
| 7 | 1 | 0 | 1 | 0 | 1 | 1 | 0011 |
| 8 | 1 | 1 | 0 | 1 | 0 | 1 | 1101 |
| 9 | 0 | 1 | 1 | 0 | 1 | 0 | 1010 |
| 10 | 1 | 0 | 1 | 1 | 0 | 1 | 0101 |
| 11 | 0 | 1 | 1 | 1 | 1 | 0 | 1110 |
| 12 | 1 | 0 | 1 | 1 | 1 | 1 | 0111 |
| 13 | 1 | 1 | 0 | 1 | 1 | 1 | 1111 |
| 14 | 1 | 1 | 0 | 0 | 1 | 1 | 1011 |
| 15 | 1 | 1 | 0 | 0 | 0 | 1 | 1001 |
| 16 | 0 | 1 | 1 | 0 | 0 | 0 | 1000 |

chacun de ces circuits comporte une porte OU-EXCLUSIVE, EX1, EX2, EX3 et EX4 respectivement dont les sorties sont reliées respectivement aux entrées E1, E2, E3 et E4 du circuit logique combinatoire 4 à tester. Les premières entrées de ces portes reçoivent respectivement les signaux SFF1, SFF2, SFF3 et SFF4 et les deuxièmes entrées sont connectées à la sortie des portes ET à deux entrées références par A1, A2, A3 et A4. Une des entrées de ces portes A1, A2, A3 et A4 est reliée à la sortie d'un circuit de commande 60 du dispositif de test pour recevoir un signal $\emptyset_{INV}$ et les deuxièmes entrées de ces portes sont connectées respectivement aux sorties des bascules FG1, FG2, FG3 et FG4.

Tout le générateur 1 fonctionne grâce aux signaux fournis par un circuit de commande 60. Ce circuit 60 utilise les signaux d'une horloge 70 qui peut soit être incorporée au générateur, soit faire partie du circuit à tester. Il est à noter que ce circuit de commande 60 est standard, c'est-à-dire que sa structure est indépendante du nombre d'entrées $E_I$ du circuit à tester.

Avant d'expliquer plus en détail l'invention on rappelle quelques structures d'éléments construits en logique C.MOS qui vont faire partie des circuits de l'invention. A la figure 2, on a déjà montré une porte NON-ET; à la figure 3, on représente un circuit inverseur; l'entrée EV de cet inverseur est reliée aux grilles des transistors MOS de type "n" et de type "p" portant respectivement les références 85 et 86; les trajets drain-sources de ces transistors branchés en série sont connectés entre la tension d'alimentation $V_{DD}$ et la masse $V_{SS}$. La sortie IS est prélevée à la connexion des deux drains, des transistors 85 et 86. En technologie C.MOS on utilise souvent des organes de transfert entre une borne d'entrée ET et une sortie ST. Entre ces bornes (voir figure 4), on a interconnecté le trajet source-drain d'un transistor MOSn 90 et d'un transistor MOSp 91. Ce trajet peut être rendu ouvert ou fermé selon la valeur logique $\emptyset_T$ ou $\overline{\emptyset_T}$ appliquée aux grilles des transistors 90 et 91.

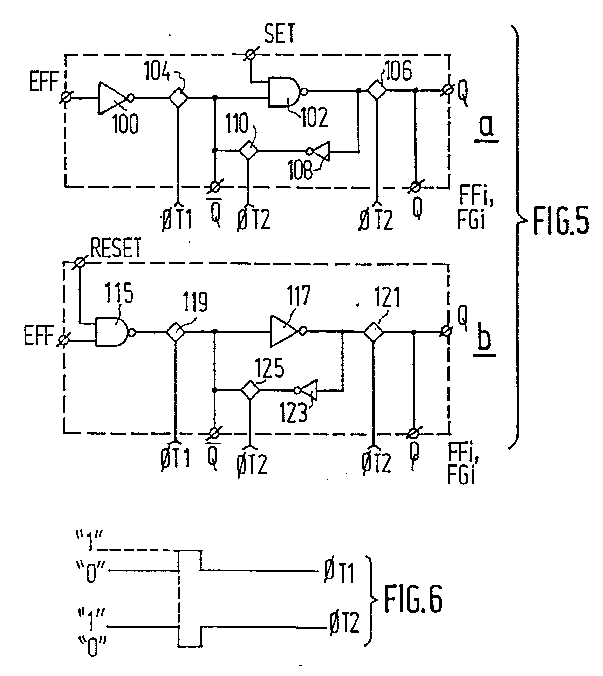

Les figures 5a et 5b représentent des structures de cellules possibles pour les bascules FF1 à FF4 et FG1

**EP 0 229 433 B1**

à FG4. A la figure 5a on montre une structure de cellules avec une entrée SET active sur un "0" logique pour initialiser cette bascule à "1" (le signal à sa sortie Q prend la valeur "1"). La bascule de la figure 5a est munie d'une entrée EFF connectée à l'entrée d'un inverseur 100 dont la sortie est connectée à une entrée d'une porte NON-ET 102 par l'intermédiaire d'un organe de transfert 104 commandé par un signal $\emptyset_{T1}$. L'entrée SET est connectée à l'entrée restante de la porte NON-ET 102 dont la sortie est reliée à la sortie Q par l'intermédiaire d'un organe de transfert 106 commandé par un signal $\emptyset_{T2}$. La sortie de la porte 102 est aussi reliée à l'entrée d'un inverseur 108 dont la sortie est reliée à la sortie $\overline{Q}$ par l'intermédiaire d'un organe de transfert 110 commandé par $\emptyset_{T2}$. Les signaux $\emptyset_{T1}$ et $\emptyset_{T2}$ sont des signaux pratiquement complémentaires non recouvrants comme l'exige le fonctionnement des circuits en technologie C.MOS actifs, selon la cadence de traitement.

A la figure 5b, on montre une cellule avec une entrée RESET active sur un "0" logique pour initialiser cette bascule à "0" (le signal à sa sortie Q prend la valeur "0"). La bascule de la figure 5b est munie d'une entrée EFF connectée à l'une des deux entrées d'une porte NON-ET 115; la deuxième entrée est reliée à l'entrée RESET. La sortie de cette porte NON-ET 115 est reliée à l'entrée d'un inverseur de signaux logiques 117 par l'intermédiaire d'un organe de transfert 119 activé par les signaux $\emptyset_{T1}$. La sortie de cet organe 119 constitue la sortie $\overline{Q}$ de la bascule. Un organe de transfert 121 activé par les signaux $\emptyset_{T2}$ est inséré entre la sortie Q de la bascule et la sortie de l'inverseur 117. L'entrée d'un dernier inverseur de signaux logiques 123 est connectée à la sortie de l'inverseur 117 tandis que sa sortie est reliée à la sortie $\overline{Q}$ par l'intermédiaire d'un organe de transfert 125 activé par les signaux $\emptyset_{T2}$.

La figure 6 montre l'allure des signaux $\emptyset_{T1}$ et $\emptyset_{T2}$ qui ne sont jamais actifs (valeur logique "1") en même temps.

A la figure 1 les cellules FF1, FF2, FF3, FF4, FG2, FG3 et FG4 sont du type montré à la figure 5b c'est-à-dire que leur entrée RESET reçoit un signal RSS, alors que la cellule FG1 est du type montré à la figure 5a c'est-à-dire que son entrée SET reçoit le signal RSS. Le générateur 30 évolue au rythme des signaux $\emptyset_{BC}$ et le circuit 40 au rythme des signaux $\emptyset_{AC}$.

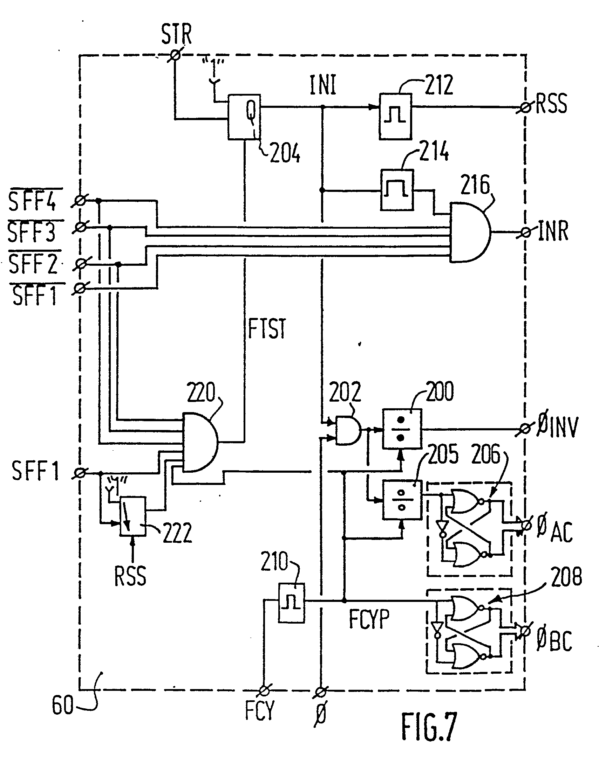

La figure 7 montre en détail le circuit de commande. Le signal d'horloge $\emptyset$ est appliqué à un premier diviseur de fréquence 200 par l'intermédiaire d'une porte ET 202 qui peut être rendue passante ou bloquée sous l'influence d'un signal INI fourni à la sortie Q d'une bascule 204. Le signal de sortie du diviseur 200 est le signal $\emptyset_{INV}$. Un deuxième diviseur de fréquence 205 fournit les signaux $\emptyset_{AC}$ par l'intermédiaire d'une bascule 206 qui permet de former un ensemble de signaux ne se recouvrant pas, nécessaires pour le fonctionnement du circuit de sélection d'éléments binaires 40. L'allure de ces signaux est à rapprocher de celle des signaux $\emptyset_{T1}$ et $\emptyset_{T2}$ de la figure 6. De même une bascule 208 permet à partir des signaux de sortie FCYP d'un circuit monostable 210 d'élaborer une combinaison de signaux $\emptyset_{BC}$ pour la progression du générateur de séquence 30. L'entrée de ce circuit monostable 210 reçoit le signal FCY. La bascule 204 passe à l'état "1" dès qu'un signal de démarrage de test STR devient actif, déclenché par l'utilisateur lorsqu'il veut effectuer un test. Le signal INI à la sortie de cette bascule 204 reste donc à "1" tant que le processus de test de déroule.

Le passage à "1" du signal INI déclenche, au moyen d'un circuit monostable 212, une courte impulsion d'initialisation RSS pour les différents circuits et déclenche aussi une longue impulsion d'une durée supérieure à la période du signal $\emptyset_{BC}$. Cette impulsion est formée par un circuit monostable 214; c'est à partir de cette longue impulsion que l'on forme le signal INR. Ce signal apparaît à la sortie d'un décodeur 216 fournissant un signal "1" si les signaux $\overline{SFF1}$, $\overline{SFF2}$, $\overline{SFF3}$, $\overline{SFF4}$ et le signal de sortie du circuit monostable 214 sont égaux à "1".

Pour arrêter le processus de test on détecte la deuxième apparition du mot "1000" c'est-à-dire le vecteur n° 16 du Tableau IV. Pour cela, on a prévu un décodeur 220 ne fournissant un signal de remise à zéro pour la bascule 204 que si les signaux $\overline{SFF2}$, $\overline{SFF3}$, $\overline{SFF4}$, SFF1, FCYP et le signal de sortie d'une bascule 222 sont égaux à "1". La bascule 222 passe à l'état "1" pour le passage de "1" à "0" du signal SFF1.

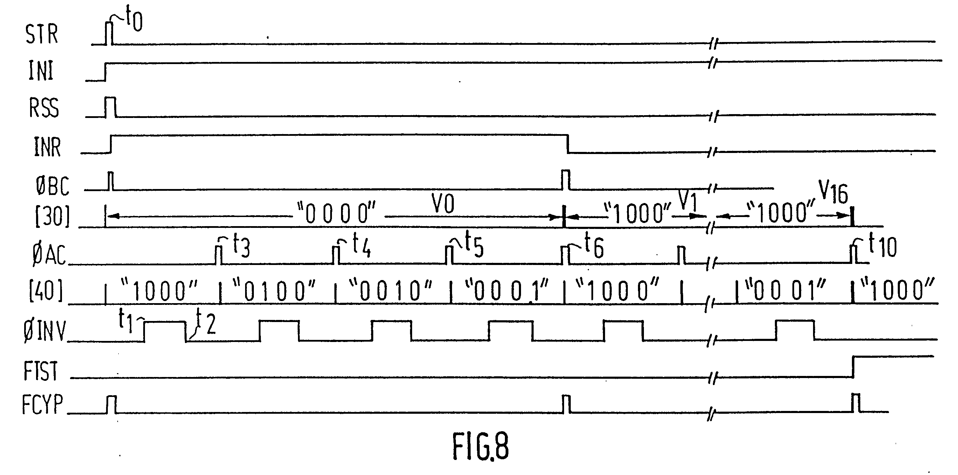

Il est possible maintenant d'expliquer le fonctionnement du circuit 60. On se reporte alors à la figure 8. Tout commence à l'instant $t_0$ où une impulsion de démarrage STR apparaît. Le signal INI prend la valeur "1". L'impulsion d'initialisation RSS est formée, ce qui initialise d'une part le générateur 30 de sorte que celui-ci fournit le vecteur n° 0 "0000" et d'autre part le circuit de sélection d'éléments binaires de sorte qu'il fournit le mot binaire "1000", ce qui entraîne l'activation du signal FCY. Alors l'impulsion FCYP du circuit 210 remet à zéro les circuits diviseurs 200 et 205. Il faut bien remarquer que le signal $\emptyset_{BC}$ déclenché par le signal FCYP n'a aucune influence sur le générateur 30 car l'impulsion RSS est suffisamment longue pour "étouffer" le signal $\emptyset_{BC}$. On notera qu'alors le signal $\emptyset_{INV}$ a la valeur "0". Comme la porte 202 est ouverte par le signal INI le circuit 200 fournit à l'instant $t_1$ un signal "1" puis à l'instant $t_2$ un signal "0". A l'instant $t_3$ c'est au tour du circuit diviseur 205 de fournir un signal actif ($\emptyset_{AC}$) de sorte que le contenu du circuit de sélection d'éléments binaires 40 devient "0100"; ce contenu devient successivement aux instants $t_4$, $t_5$ "0010" et "0001". A l'instant $t_6$, le signal FCY redevient actif et active le circuit monostable 210 de sorte qu'apparaît un signal $\emptyset_{BC}$ pour le générateur de séquence 30. Comme à son entrée le signal INR a la valeur "1" le vecteur élaboré par ce générateur est donc "1000", ce qui fait retomber à "0" le signal INR. Le générateur de séquence va pouvoir alors fournir les différents vecteurs du Tableau IV. Le processus se déroule ensuite pour chaque vecteur de la manière indiquée ci-dessus, jusqu'au moment où le vecteur V16 est engendré par le générateur 30 et où le contenu du circuit 40 est "0001"; à l'instant $t_{10}$, le signal $\emptyset_{AC}$ devient actif de sorte que le contenu du circuit devient "1000"; alors le signal du décodeur devient actif et la

6

bascule 204 passe à l'état "0" bloquant la porte 202; les signaux $\emptyset_{INV}$ et $\emptyset_{AC}$ n'évoluent plus, ce qui entraîne que le signal FCY ne sera plus actif. Le circuit de commande est donc stoppé, le processus de test étant terminé.

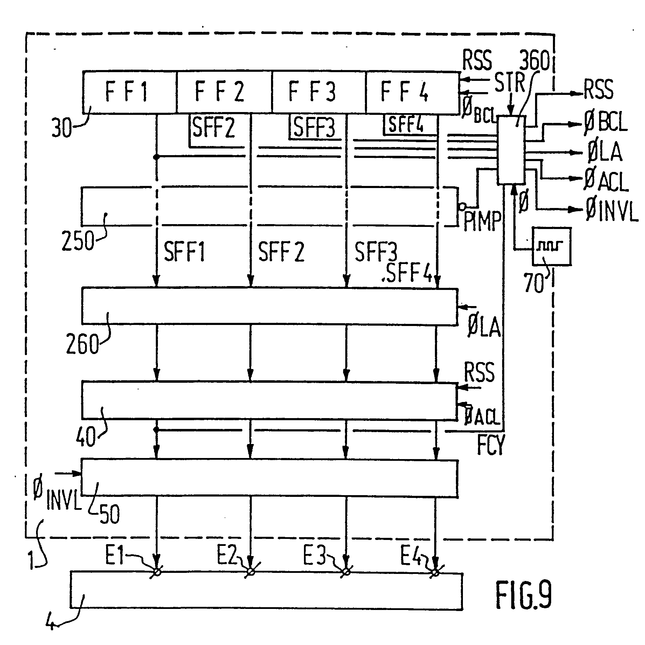

A la figure 9 on montre un exemple de réalisation préféré d'un circuit générateur de séquences de test. Ce générateur apporte l'avantage que $2^N-1$ vecteurs sont engendrés alors que le générateur de la figure fournit $2^N$ vecteurs comme cela sera expliqué dans la suite du présent mémoire. Il est formé du même générateur de séquences pseudo-aléatoire 30 auquel est adjoint un détecteur de parité 250; ce détecteur fournit un signal PIMP dont la valeur logique indique que le vecteur élaboré par le générateur 30 a un nombre pair ou un nombre impair d'éléments binaires de valeur "1". Selon le critère de parité choisi (par exemple on ne va considérer que les vecteurs ayant un nombre impair d'éléments binaires de valeur "1"), le vecteur sera ou non enregistré dans une mémoire tampon 260. A la sortie de cette mémoire tampon on a disposé le circuit de sélection d'élément binaire 40 et le circuit d'inversion 50. Le fonctionnement du circuit générateur est régi par les signaux élaborés par le circuit de commande 360 qui fournit les signaux d'initialisation RSS pratiquement sans changement par rapport à ceux du circuit 60. Par contre l'apparition des signaux de progression du circuit 30 a été modifiée et ces signaux portent la référence $\emptyset_{BCL}$. Ce circuit de commande doit aussi fournir les signaux $\emptyset_{LA}$ pour commander le changement dans le registre tampon 260 du vecteur élaboré par les circuits 250, les signaux $\emptyset_{ACL}$ pour la progression du circuit de sélection d'élément binaire. Les signaux pour le circuit 50 portent la référence $\emptyset_{INVL}$.

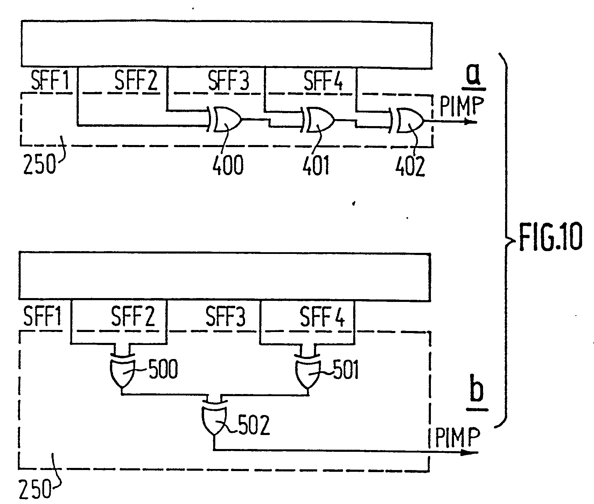

La figure 10a montre un premier exemple de réalisation du détecteur de parité 250; il est formé de trois portes OU-EXCLUSIF 400, 401 et 402. Les deux entrées de la porte 400 sont reliées aux sorties SFF1 et SFF2, les deux entrées de la porte 401 sont reliées respectivement à la sortie SFF3 et à la sortie de la porte 400 et les deux entrées de la porte 402 à la sortie SFF4 et à la sortie de la porte 401. Le signal PIMP apparaît à la sortie de la porte 402. Cette structure a l'avantage qu'elle est modulaire, c'est-à-dire que le motif se répète identiquement à lui-même en fonction du nombre d'étages du générateur de séquences pseudo-aléatoires et qu'elle ne nécessite par une surface d'intégration importante.

La figure 10b montre un deuxième exemple de réalisation du détecteur de parité 250; il est formé de trois portes OU-EXCLUSIF 500, 501 et 502. Les deux entrées de la porte 500 sont reliées aux sorties SFF1 et SFF2. Les deux entrées de la porte 501 sont reliées aux sorties SFF3 et SFF4 et les deux entrées de la porte 502 sont reliées aux sorties des portes 500 et 501. Le signal PIMP apparaît à la sortie de la porte 502. Ce circuit élabore plus rapidement que le précédent le signal PIMP.

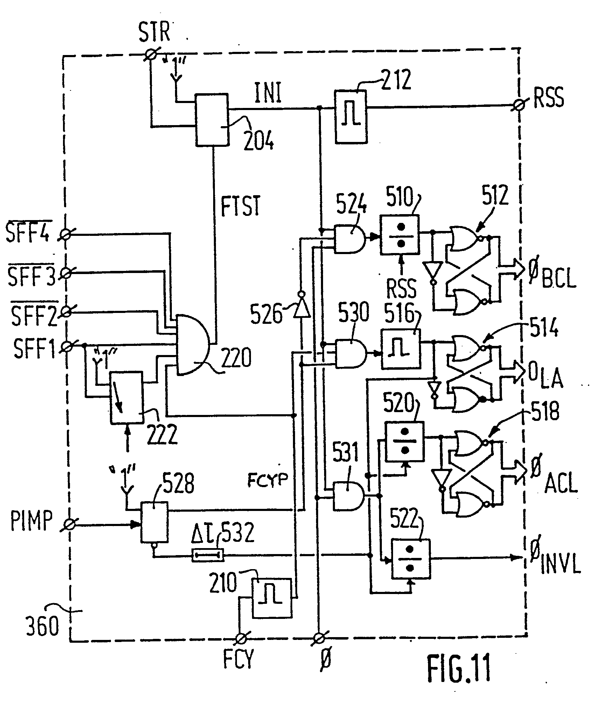

Le circuit de commande 360 a une structure qui est représentée en détail à la figure 11. Dans ce circuit il n'est plus nécessaire de prévoir les éléments d'élaboration du signal INR puisqu'à l'initialisation, on évite le vecteur "0000". L'initialisation s'effectue dans cet exemple par le vecteur "1000". Par contre, on a choisi un diviseur de fréquence qui fournit des signaux à une fréquence bien plus élevée que l'apparition des signaux $\emptyset_{BC}$ élaborés par le circuit 60. Ces signaux de sortie du diviseur 510 transitent dans une bascule 512; aux sorties de cette bascule on recueille les signaux $\emptyset_{BCL}$ nécessaires pour la progression du générateur 30. Les signaux $\emptyset_{LA}$ pour le chargement du registre tampon 260 sont élaborés par une bascule 514 à partir des signaux de sortie d'un circuit monostable 516. Les signaux $\emptyset_{ACL}$ pour la progression du circuit de sélection d'éléments binaires sont élaborés par une bascule 518 à partir des signaux de sortie d'un circuit diviseur de fréquence 520. Les signaux $\emptyset_{INVL}$ proviennent directement de la sortie d'un circuit diviseur de fréquence 522. Le signal appliqué à l'entrée du circuit diviseur 510 est le signal de sortie d'une porte ET 524 à trois entrées. Une de ces entrées reçoit le signal INI élaboré par les mêmes éléments que ceux du circuit 60. Une deuxième entrée est connectée par l'intermédiaire d'un inverseur de signaux logiques 526 à la sortie Q d'une bascule 528 et la troisième entrée reçoit les signaux d'horloge $\emptyset$. Les signaux appliqués aux entrées du circuit monostable 516 sont issus d'une porte ET 530 à trois entrées. La première reçoit le signal INI, la deuxième, le signal de sortie du circuit monostable 210 dont la fonction a été définie lors de la description du circuit 60 et la troisième, le signal de sortie Q de la bascule 528. Les signaux appliqués aux entrées des circuits diviseurs 520 et 522 proviennent d'une porte ET 531 à deux entrées dont l'une reçoit les signaux $\emptyset$ et l'autre le signal INI. La bascule 528 est mise à l'état "1" par le signal PIMP indiquant qu'un nombre impair d'éléments binaires est fourni par le générateur 30. Cette bascule est remise à l'état "0" par le signal d'un organe de retard 532 dont l'entrée est connectée à la sortie du circuit monostable 516; le retard $\Delta\tau$ amené par cet organe 532 correspond au temps nécessaire pour assurer le chargement du vecteur élaboré par le générateur 30 dans le registre tampon 260. Le diviseur 510 est initialisé par le signal RSS tandis que les diviseurs 520 et 522 le sont par le signal de sortie du circuit 516. Dès que le signal de sortie de la bascule 528 est à "1" la porte 524 est fermée, ce qui "gèle" le vecteur fourni par le générateur 30. A l'initialisation le signal FCY prend la valeur indiquant une fin de cycle, une impulsion à la sortie du circuit 210 est transmise au circuit 516 de sorte que le signal $\emptyset_{LA}$ est activé et les circuits diviseurs 520 et 522 sont initialisés. Les signaux $\emptyset_{ACL}$ et $\emptyset_{INV}$ vont dérouler les signaux comme ce qui a déjà été dit. Puis la bascule 528 va être remise à zéro après le laps de temps $\Delta\tau$. La porte 524 est ouverte et à une fréquence relativement rapide, le générateur 30 va progresser jusqu'à ce que le vecteur élaboré présente la parité requise, la porte 524 est fermée et la porte 530 est ouverte pour qu'à la prochaine impulsion FCYP on déclenche une nouvelle opération de chargement. A la fin du test détectée par le décodeur 220 le signal INI prend la valeur "0" ce qui bloque les portes 524, 530. Le processus de test est alors terminé. Le signal FST prend la valeur "1" et il est alors possible de déclencher la lecture du circuit de sortie 2.

On constate que cet exemple de réalisation diminue par deux le nombre de vecteurs effectivement appliqués aux bornes du circuit à tester tout en respectant l'aspect systématique du test.

En effet si on considère le premier exemple de réalisation, soit par exemple le vecteur n° 3, 0010, après inversion pour la première broche, on obtient la séquence:

$$0010$$
$$1010$$
$$0010$$

On s'aperçoit que cette séquence a le même effet que la séquence obtenue à partir du vecteur 9 qui, lui, donne alors la séquence:

$$1010$$
$$0010$$
$$1010$$

Les séquences 101 et 010 appliquées à une certaine broche donnent des résultats de test identiques.
Le deuxième exemple de réalisation évite donc cette redondance de test.

## Revendications

1. Dispositif de test d'un circuit logique combinatoire (4), comportant d'une part un circuit générateur de séquences de test (1) pour appliquer à N entrées du circuit logique combinatoire des signaux logiques de test et d'autre part un circuit de sortie (2) pour analyser les signaux de sortie du circuit logique combinatoire (4), ces séquences de test consistant à appliquer successivement à chacune des N entrées une suite alternée, au moins deux fois, de "1" et de "0" logiques tandis qu'aux autres entrées est appliqué un mot de N−1 éléments binaires pour assurer la transmission de ladite suite alternée vers la sortie du circuit logique combinatoire (4), caractérisé en ce que le générateur de séquences de test (1) est constitué d'un générateur de séquences pseudo-aléatoire (30) pour fournir des vecteurs à N éléments binaires formé à partir d'un registré à décalage auquel est associé un réseau de réinjection, d'un circuit de sélection d'élément binaire (40) pour sélectionner succesivement chacun des N éléments binaires et d'un circuit d'inversion (50) pour inverser au moins deux fois l'élément binaire sélectionné.

2. Dispositif de test selon la revendication 1, caractérisé en ce que pour chaque vecteur du générateur de séquences pseudo-aléatoire (30) le circuit d'inversion (50) est commandé pour inverser au moins deux fois chacun des N éléments binaires.

3. Dispositif de test selon la revendication 2, caractérisé en ce qu'il est prévu des moyens (250, 260) pour diminuer de deux les vecteurs de test en fonction d'un critère de parité effectué sur le nombre d'éléments binaires du vecteur égaux à "1".

4. Dispositif de test selon la revendication 3, caractérisé en ce que le critère de parité consiste à choisir un nombre impair d'éléments binaires pour les vecteurs.

## Patentansprüche

1. Anordnung zum Prüfen einer logischen Verknüpfungsschaltung (4), einerseits mit einer Prüffolgengeneratorschaltung (1) zum Beliefern von N Eingängen der logischen Verknüpfungsschaltung mit logischen Prüfsignalen und andererseits mit einer Ausgangsschaltung (2) zum Analysieren der Ausgangssignale der logischen Verknüpfungsschaltung (4), wobei diese Prüffolgen darin bestehen, daß aufeinanderfolgend jedem der N Eingänge eine wechselnde Reihe, wenigstens zweimal, logischer "1"- und "0"-Werte zugeführt wird, während an die anderen Eingänge ein Wort von N-1-Binärelementen zum Gewährleisten der Übertragung dieser wechselnden Reihe auf den Ausgang der logischen Verknüpfungsschaltung (4) gelegt wird, dadurch gekennzeichnet, daß der Prüffolgengenerator (1) aus einem Pseudozufallsfolgengenerator (30) zum Ausgeben von Vektoren für N Binärelemente, der aus einem Schieberegister besteht, dem ein Rückkopplungsnetz zugeordnet ist, aus einer Binärelementwählschaltung (40) zum aufeinanderfolgenden Wählen jedes der N Binärelemente und aus einer Umkehrschaltung (50) zum Umkehren von wenigstens zweimal dem ausgewählten Binärelement zusammengesetzt ist.

2. Anordnung nach Anspruch 1, dadurch gekennzeichnet, daß für jeden Vektor des Pseudozufallsgenerators (30) die Umkehrschaltung (50) zum Umkehren von wenigstens zweimal jedem der N Binärelemente gesteuert wird.

3. Anordnung nach Anspruch 2, dadurch gekennzeichnet, daß zum Verringern der Prüfvektoren um zwei abhängig von einem an einer Anzahl von Binärelementen "1" des Vektors durchgeführten Paritätskriterium Mittel (250, 260) vorgesehen sind.

4. Anordnung nach Anspruch 3, dadurch gekennzeichnet, daß das Paritätskriterium aus der Wahl einer Anzahl ungerader Binärelemente für die Vektoren besteht.

**Claims**

1. A test device for a combinational logic circuit (4), comprising on the one hand a circuit (1) for generating test sequences in order to apply logic test signals to N inputs of the combinational logic circuit, and comprising on the other hand an output circuit (2) for analysing the output signals of the combinational logic circuit (4), which test sequences consists of successively supplying each of the N inputs with an at least twice alternating series of logic "1" and "0" while applying to the other inputs an N-1 bit word in order to ensure the transmission of said alternating series to the output of said combinational logic circuit (4), characterized in that the test sequence generator (1) is formed by a pseudo-random sequence generator (30) which serves to supply N-bit vectors and which is formed on the basis of a shift register with an associated reinjection network, by a bit selection circuit (40) for successively selecting each of the N bits, and by an inversion circuit (50) for inverting the selected bit at least twice.

2. A test device as claimed in Claim 1, characterized in that for each vector of the pseudo-random sequence generator (30) the inversion circuit (30) is controlled so as to invert each of the N bits at least twice.

3. A test device as claimed in Claim 2, characterized in that there are provided means (250, 260) for reducing the test vectors by two as a function of a parity criterion applied to the number of vector bits equal to "1".

4. A test device as claimed in Claim 3, characterized in that the parity criterion consists in choosing an odd number of bits for the vectors.

FIG.1

EP 0 229 433 B1

FIG.2

FIG.3

FIG.4

FIG.5

FIG.6

FIG.7

FIG.8

EP 0 229 433 B1

FIG.9

FIG.10

**FIG.11**